# EUROPÄISCHE PATENTSCHRIFT

(11) **EP 2 554 030 B1**
(45) Veröffentlichungstag und Bekanntmachung des Hinweises auf die Patenterteilung: **15.03.2017**
(21) Anmeldenummer: 11711317.5
(22) Anmeldetag: 25.03.2011
(51) Int. Cl.: H05K 7/14

(54) **BUSFÄHIGES ANSCHLUSSMODUL**
CONNECTION MODULE BEING CAPABLE OF SERVING AS A BUS
MODULE DE RACCORDEMENT COMPATIBLE BUS

(30) Priorität: 31.03.2010 DE 202010004410 U
(43) Veröffentlichungstag der Anmeldung: 06.02.2013
(73) Patentinhaber: Weidmüller Interface GmbH & Co. KG, 32758 Detmold (DE)
(72) Erfinder: BERGER, Timo, 33102 Paderborn (DE); FEHLING, Stephan, 32791 Lage (DE); KULTURIDI, Georg, 32758 Detmold (DE); LÜCKE-JANSSEN, Daniela, 49504 Lotte (DE); NIGGEMANN, Matthias, 32694 Dörentrup (DE); OPITZ, Gordon, 32130 Enger (DE); PÜSCHNER, Klaus, 32760 Detmold (DE); SCHNATWINKEL, Michael, 32051 Herford (DE); SCHUMACHER, Ralf, 32657 Lemgo (DE); WOHLGEMUTH, Klaus, 32689 Kalletal (DE)
(74) Vertreter: Specht, Peter
(86) Internationale Anmeldenummer: PCT/EP2011/054606
(87) Internationale Veröffentlichungsnummer: WO 2011/120881

(56) Entgegenhaltungen:
- EP-A1- 1 622 440
- EP-A2- 0 909 122
- DE-A1- 2 359 452
- DE-A1- 19 651 961
- DE-A1- 19 964 156

## Beschreibung

Die Erfindung betrifft ein busfähiges Anschlussmodul zur Steuerung und/oder Überwachung technischer Prozesse und/oder zur Industrie- und/oder Gebäudeautomatisierung nach dem Oberbegriff des Anspruchs 1 und eine Reihung aus derartigen Anschlussmodulen.

Anschlussmodule sind beispielsweise aus der gattungsgemäßen EP 0 364 618 B1, der DE 44 02 002 A1, der EP 95 113 730 A1 und der DE 199 64 156 A1 bekannt. Während die EP 95 113 730 A1 Anschlussmodule mit einem eher blockartigen Aufbau mit einer Mehrzahl an Anschlussebenen zum Anschluss externer Leiter offenbart, ist aus der gattungsgemäßen DE 199 64 156 A1 eine Mischbauweise mit scheibenartigen Geräten mit jeweils zwei zueinander parallelen Anschlussebenen und blockartigen Geräten mit einer Mehrzahl aus Anschlussebenen bekannt. Die EP 0 909 122 A23 offenbart die Merkmale a), c) und d) des Oberbegriffs des Anspruchs 1.

Die gattungsgemäße EP 0 364 618 B1 derselben Anmelderin weist Basisklemmenträger auf, in die Druckkontakte eingesetzt sind, die einander im aneinander gereihten Zustand kontaktieren und die derart über mehrere Module hinweg durchgehende Busleitungen ausbilden. Zum Kontaktieren einer Leiterplatte einer auf die Basisklemmenträger aufsetzbaren Elektronikeinheit dienen Steckverbinder.

Gegenüber diesem an sich bewährten Aufbau des Standes der Technik ist die Aufgabe der Erfindung, ein einfach handhabbares Anschlussmodul mit einem besonders klar strukturierten und die Elektronik gut schützenden Aufbau bereit zu stellen.

Die Erfindung löst diese Aufgabe durch den Gegenstand des Anspruchs 1. Vorteilhafte Ausgestaltungen sind den Unteransprüchen zu entnehmen.

Der Rahmen ist in Anreihrichtung vorzugsweise jeweils offen, so dass das Elektronikgehäuse in diesem Bereich auch einen Teil der Außenwand des Anschlussmoduls bildet. In den Rahmen, der geöffnet werden kann, kann das Elektronikgehäuse eingesetzt werden. Im Rahmen ist es nach außen hin besonders gut geschützt und gesichert.

Nach einer vorteilhaften Variante der Erfindung weist der Basisklemmenträger einen U-förmigen Aufbau mit einem Grundschenkel und Seitenschenkeln auf, so dass zwischen dem Grundschenkel und den Seitenschenkeln ein Aufnahmeraum ausgebildet wird, in welchen das Elektronikgehäuse einsetzbar ist. In diesem ist das Elektronikgehäuse zu drei Seiten hin gut geschützt, auch wenn die Anschlusseinheit noch nicht aufgesetzt ist.

Es ist praktisch und zweckmäßig, wenn die Anschlusseinheit schwenkbar und/oder lösbar an dem Basisklemmenträger angeordnet ist.

Es wäre zudem alternativ denkbar, die Seitenschenkel verschieden lang auszulegen oder aber die Seitenschenkel nicht an die Basisklemmenträger sondern an die Anschlusseinheit anzuformen, so dass der U-förmige Aufnahmeraum in der Anschlusseinheit gebildet wird (hier nicht dargestellt).

Es wäre zudem alternativ denkbar, die Seitenschenkel auf die Basisklemmenträger und die Anschlusseinheiten quasi zu "verteilen", so dass der Aufnahmeraum z.B. halb im Basisklemmenträger und halb in der Anschlusseinheit ausgebildet würde (hier nicht dargestellt).

Vorzugsweise ist je Basisklemmenträger jeweils eines der Elektronikgehäuse vorgesehen.

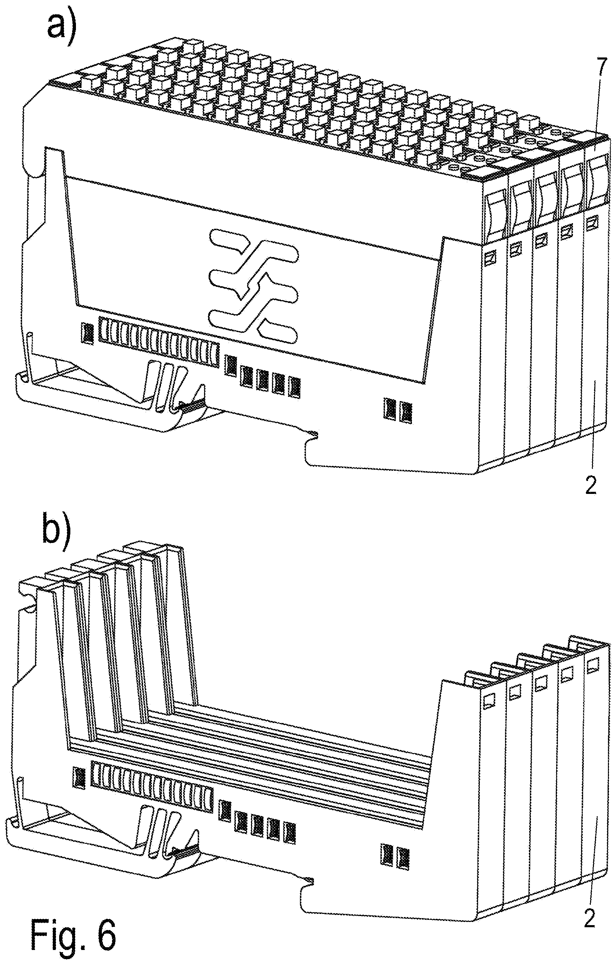

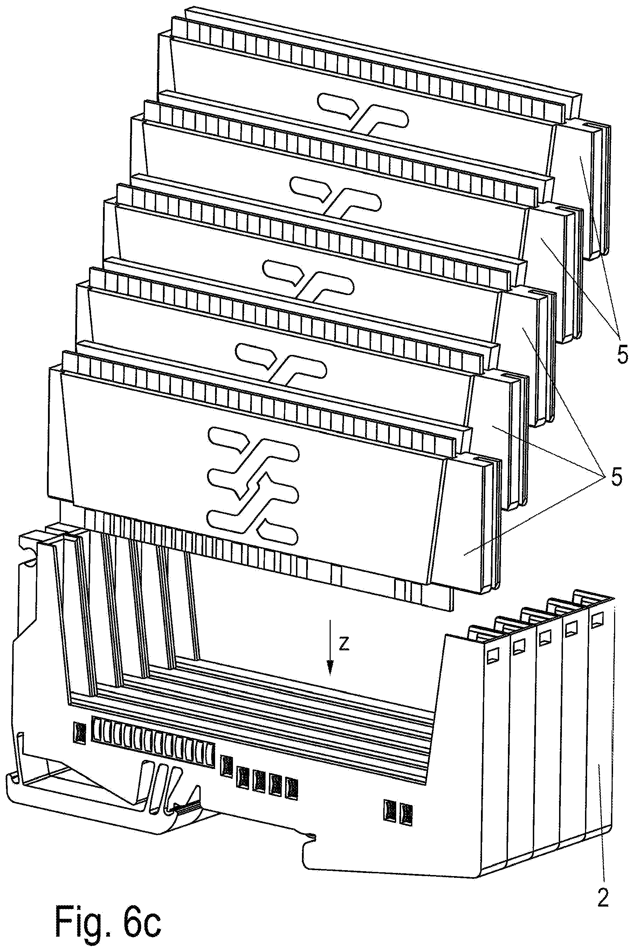

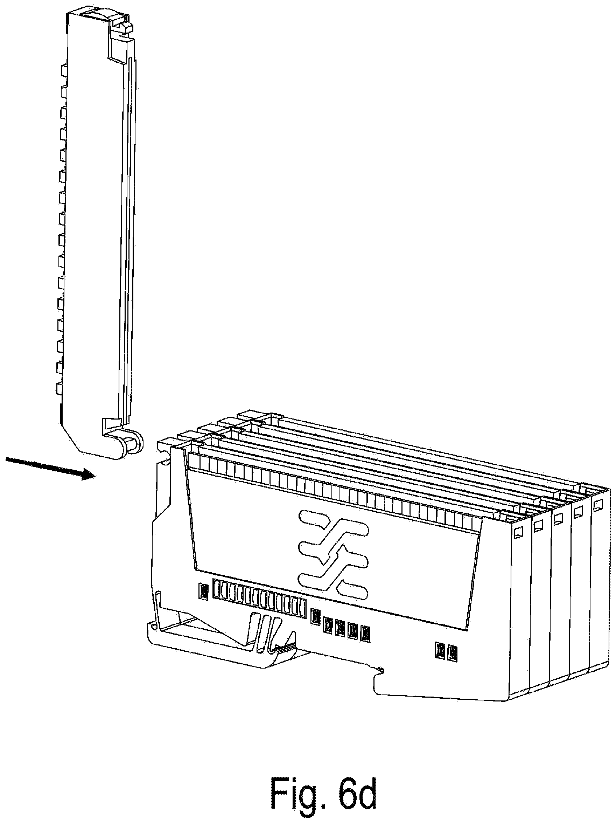

Es ist aber alternativ auch denkbar, dass in den Aufnahmeraum, welcher in einer Reihung von Basisklemmenträgern gebildet wird (siehe Fig. 6), ein sich über mehrere der Basisklemmenträger erstreckendes Elektronikgehäuse einsetzbar ist bzw. eingesetzt ist.

Es ist zudem auch denkbar, dass eine Anschlusseinheit mehrere der Basisklemmenträger übergreift (z.B. nach Art einer schwenkbaren Abdeckung mit Anschlussvorrichtungen für externe Leiter).

Es ist durch die erfindungsgemäße Konstruktion auch denkbar, auf eine Verriegelung der Elektronik in dem Rahmen, welches aus dem U-förmigen Aufnahmeraum und der diese verschließenden Anschlusseinheit in Leistenform gebildet wird, zu verzichten. In einer bevorzugten Ausführungsform bilden die Seitenschenkel des Basisklemmenträgers zudem eine gemeinsame Rückwand und Frontwand. In dieser Ausführungsform bildet der Basisklemmenträger ein sich um das Elektronikgehäuse schließendes Gehäuse. Zudem ist es bevorzugt, dass das Anschlussmodul Dichtungen zum dichtenden Verschließen des Anschlussmoduls und/oder mehrerer aneinandergereihter Anschlussmodule aufweist. In geschlossener Form des Basisklemmenträgers mit zusätzlichen Dichtungen ist das Anschlussmodul in einer hohen Schutzart, beispielsweise IP67, fertigbar.

Als Vorteil nochmals besonders zu erwähnen ist die Möglichkeit, eine stehende Verdrahtung auszubilden, bevor die Elektronik eingesetzt wird. Es ist zudem denkbar, eine stehende Verdrahtung mit mehreren Schnittstellen (oben, unten, links, rechts) zur Elektronik zu bilden.

Bevorzugt weist das Anschlussmodul Kontaktelemente zum elektrischen Kontaktieren von an das Anschlussmodul angereihte benachbarte Anschlussmodule auf, die im Basisklemmenträger oder in einem in den Basisklemmenträger angeordneten Kontaktmodul vorgesehen sind.

Es ist auch eine sehr geringe Modullänge bei stehender Verdrahtung und gleichzeitig hoher Kanaldichte realisierbar.

Es ist denkbar, die Anschlussebene bzw. Anschlussleiste schwenkbar und/oder durch eine andere, ggf. auch kombinierte Bewegung (schwenken, stecken, schieben, axial, rotierend) zu bedienen bzw. am Basisklemmenträger zu bewegen. Eine Einhandbedienung - vorzugsweise ohne Werkzeug - ist ebenfalls denkbar.

Eine Trapezform des Aufnahmeraums zur offenen Seite des U im Basisklemmenträger bringt den zusätzlichen Vorteil mit sich, dass durch Druck auf einen oder beide Seitenschenkel die Elektronik mit dem Elektronikgehäuse besonders leicht aus dem Basisklemmenträger lösbar ist. Die Erfindung betrifft auch eine Reihung aus den erfindungsgemäßen Anschlussmodulen.

Nachfolgend wird die Erfindung unter Bezug auf die Zeichnung anhand von Ausführungsbeispielen näher beschrieben. Es zeigt:
- Fig. 1a, b: zwei um 180° zueinander gedrehte perspektivische Ansichten eines ersten Anschlussmoduls;
- Fig. 2a: eine Seitenansicht des Anschlussmoduls aus Fig. 1a;
- Fig. 2b: eine vereinfachte, schematisierte Schnittansicht des Anschlussmoduls aus Fig. 1a durch eine Ebene parallel zur Blattebene aus Fig. 1a;
- Fig. 2c: eine Detailansicht A aus Fig. 2b;
- Fig. 2d: eine Detailansicht B aus Fig. 2b;
- Fig. 2e: eine perspektivische Ansicht des Anschlussmoduls aus Fig. 1a mit einer um einen geringen Winkel aufgeschwenkten Anschlusseinheit;
- Fig. 3a: eine perspektivische Ansicht des Anschlussmoduls aus Fig. 1a mit einer rechtwinklig aufgeschwenkten Anschlusseinheit;
- Fig. 3b: eine Detailansicht aus Fig. 3a;
- Fig. 3c: die Anordnung aus Fig. 3a nach einem Abnehmen der Anschlusseinheit;
- Fig. 4a: die Anschlusseinheit aus Fig. 1a und 3a mit aufgeschwenkter Anschlusseinheit vor einem Herausnehmen eines Elektronikgehäuses;
- Fig. 4b: die Anordnung aus Fig. 4a nach einem Herausnehmen des Elektronikgehäuses;
- Fig. 5a: eine Reihung aus einer Mehrzahl an Anschlussmodulen ohne Elektronikgehäuse;
- Fig. 5b: die Reihung aus Anschlussmodulen ohne Elektronikgehäuse aus Fig. 5a mit aufgeschwenkten Anschlusseinheiten;
- Fig. 5c: die Reihung aus Anschlussmodulen ohne Elektronikgehäuse aus Fig. 5b mit aufgeschwenkten Anschlusseinheiten und mehrere Elektronikgehäuse vor dem Einsetzen in die Anschlussmodule;
- Fig. 6a: eine Reihung aus Anschlussmodulen mit Elektronikgehäusen und Anschlusseinheiten;
- Fig. 6b: eine Reihung aus Basisklemmenträgern;
- Fig. 6c: die Reihung aus Basisklemmenträgern aus Fig. 6b mit in die Basisklemmenträger einzusetzenden Elektronikgehäusen;
- Fig. 6d: die Reihung aus Basisklemmenträgern aus Fig. 6b mit darin eingesetzten Elektronikgehäusen und einer anzubringenden Anschlusseinheit;
- Fig. 7a: eine perspektivische Ansicht einer zweiten Ausführungsform eines Anschlussmoduls mit abgenommener Anschlusseinheit;
- Fig. 7b: eine Seitenansicht der zweiten Ausführungsform des Anschlussmoduls mit aufgesetzter Anschlusseinheit;
- Fig. 7c: eine vereinfachte, schematisierte Schnittansicht des Anschlussmoduls aus Fig. 7b durch eine Ebene parallel zur Blattebene aus Fig. 7a;
- Fig. 7d: eine Detailansicht A aus Fig. 7c; und
- Fig. 7e: eine Detailansicht B aus Fig. 7c:
- Fig. 8: zeigt in den Fig. 8(a) - (c) ein erfindungsgemäßes Anschlussmodul, bei dem die Seitenschenkel des Basisklemmenträgers eine gemeinsame Rückwand und Frontwand bilden;
- Fig. 9: zeigt die Bestandteile des Basisklemmenträgers des Anschlussmoduls der Fig. 8;
- Fig. 10: zeigt zwei aneinander gereihte Anschlussmodule der Fig. 8;
- Fig. 11 - 13: zeigt verschiedenen Ausführungsformen von an einer Tragschiene aneinandergereihten Anschlussmodulen mit jeweils Basisklemmenträgern, deren Seitenschenkel jeweils eine gemeinsame Rückwand und Frontwand bilden.

Vor der Beschreibung bevorzugter Ausführungsbeispiele sei angemerkt, dass nachfolgend einige bevorzugte Ausgestaltungen auch im Detail beschrieben werden, dass die Erfindung aber nicht auf diese Ausgestaltungen beschränkt ist sondern im Rahmen der Ansprüche beliebig variiert ausgestaltet werden kann. Insbesondere sind Begriffe wie "oben", "unten", "vorne" oder "hinten" nicht einschränkend zu verstehen sondern beziehen sich lediglich auf die jeweils dargestellte Anordnung. Zudem sind, wenn einzelne Bestandteile erläutert werden, diese - wenn nicht anders erwähnt - grundsätzlich auch in mehrfacher Ausgestaltung denkbar. Unter den Schutzbereich fallen zudem auch kinematische Umkehrungen der dargestellten Anordnungen.

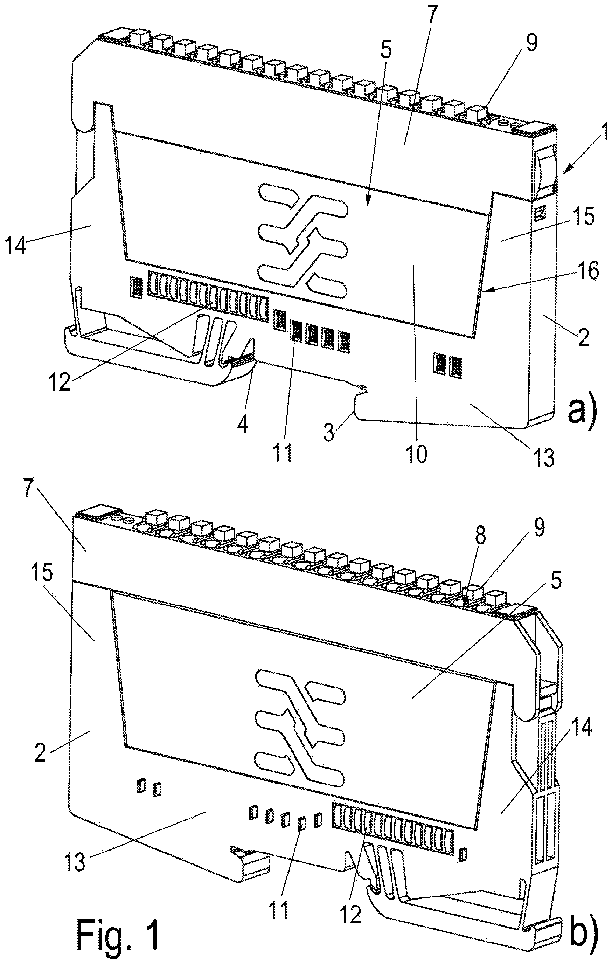

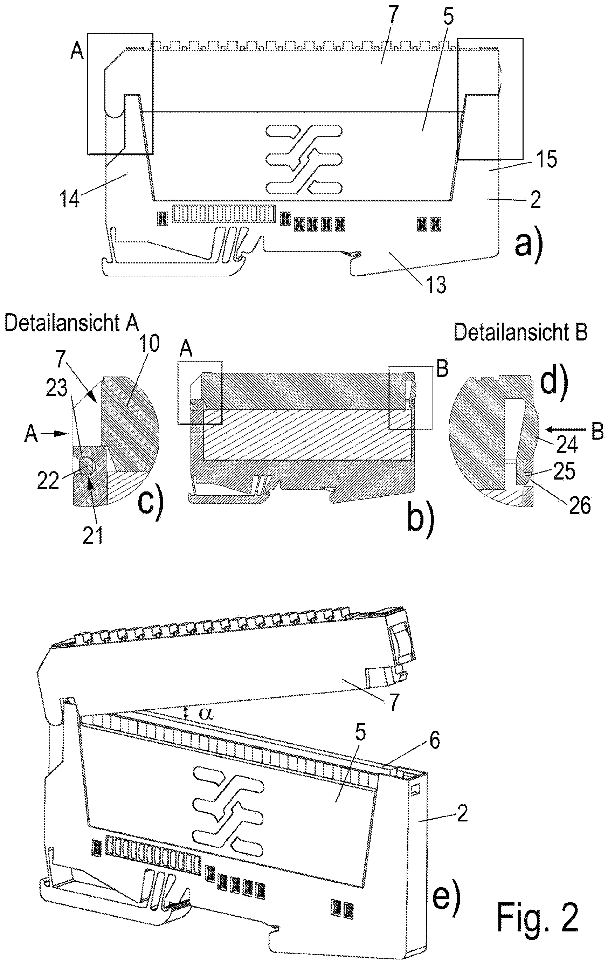

Fig. 1a, b und Fig. 2 a bis c zeigen vereinfachte Darstellungen von auf eine Tragschiene aufsetzbaren - insbesondere aufrastbaren - und auf der Tragschiene aneinander reihbaren elektrischen Anschlussmodulen 1, die beispielsweise in Steuerungssystemen der Automatisierungstechnik verwendet werden können, wo sie an ein Gateway angereiht werden. Die Kombination aus Gateway und Anschlussmodulen ermöglicht die Überwachung und/oder Steuerung externer elektrischer Geräte (Feldgeräte, Initiatoren, Aktoren usw.), welche an die Anschlussmodule 1 des erfindungsgemäßen elektrischen Gerätes anschließbar sind.

Jedes der Anschlussmodule 1 weist einen Basisklemmenträger 2 auf, der hier mit Rastmitteln 3, 4 zum Aufrasten auf eine Tragschiene (hier nicht dargestellt) versehen ist.

Auf eine derartige Ausgestaltung ist die Erfindung aber nicht beschränkt. Sie eignet sich weiter auch für anreihbare Anschlussmodule, welche auf einer anderen Montagebasis, beispielsweise einer Wand oder dgl. montierbar sind.

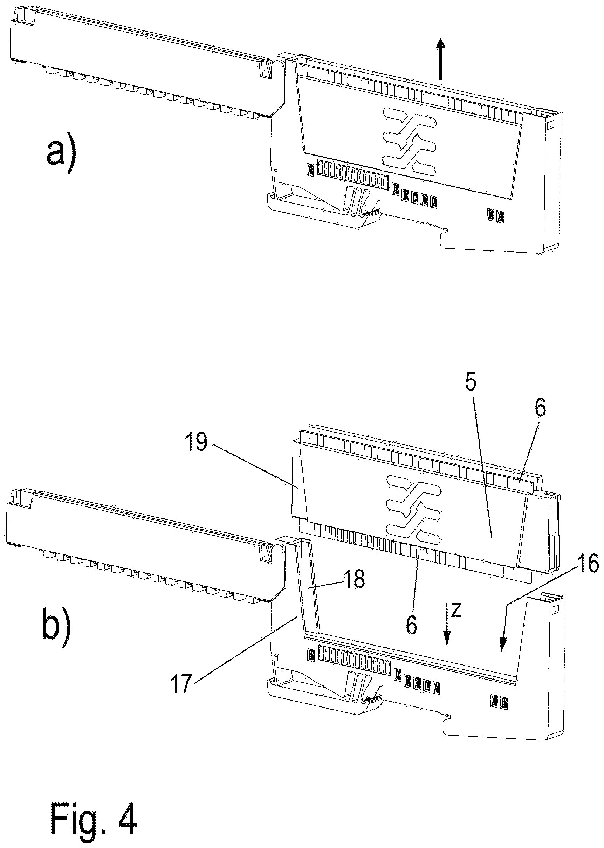

Auf den Basisklemmenträger 2 ist ein Elektronikgehäuse 5 mit wenigstens einer oder mehreren Leiterplatte(n) 6 (Fig. 2e und 4b) aufgesetzt bzw. aufsetzbar, die wiederum mit elektrischen Bauelementen bestückt sein kann/können (Fig. 1 a).

Auf den Basisklemmenträger 2 und das Elektronikgehäuse 5 ist wiederum eine Anschlusseinheit 7 mit einer Reihe von Anschlussvorrichtungen - Anschlüssen - zum Anschluss externer Leiter (hier nicht dargestellt) aufgesetzt. Diese Anschlussvorrichtungen sind vorzugsweise - aber nicht zwingend - als Anschlüsse in Direktstecktechnik (Push-In) ausgelegt, die werkzeugfrei rein durch Einstecken eines Leiters in einen Klemmstellenbereich des Anschlusses kontaktierbar sind. Im kontaktierten Zustand klemmt ein Klemmschenkel des Push-In-Anschlusses den Leiter in einem Klemmkäfig gegen eine Stromschiene. Ein Betätigungselement 9 dient hier zum Öffnen der Klemmstelle, welche unterhalb einer Öffnung 8 des Gehäuses 10 der Anschlusseinheit liegt.

Da lediglich eine einzige Reihe der Anschlussvorrichtungen 8 vorgesehen ist, kann ein Anschlussmodul 1 mit einem in Anreihrichtung besonders schmalen Aufbau realisiert werden.

Die Erfindung ist hierauf aber nicht beschränkt. Sie eignet sich auch für Anschlusseinheiten mit mehreren Reihen von Anschlussvorrichtungen 8. Die Anschlussvorrichtungen können insbesondere auch als IDC-Anschlüsse, Zugfederanschlüsse oder Schraubanschlüsse ausgebildet sein.

Zudem kann die Anschlußvorrichtung auch als wenigstens eine Steckvorrichtung ausgelegt sein, an welche eine korrespondierende Steckvorrichtung angekuppelt werden kann.

Sowohl der Basisklemmenträger 2 als auch das Elektronikgehäuse 5 als auch die Anschlusseinheit weisen einen scheibenartigen Aufbau auf und sind senkrecht zur Ebene der Fig. 2a aneinander anreihbar.

Neben den Anschlussvorrichtungen 8 der Anschlusseinheit 7 zum Anschluss externer Leiter von Feldgeräten wie Aktoren, Sensoren und dgl. weist jedes Anschlussmodul nach Fig. 1 oder 2 vorzugsweise mehrere Kontaktelemente 11 einer ersten Bauart zur Realisierung eines über mehrere Anschlussmodule in Anreihrichtung X verlaufenden ersten internen Busses und mehrere Kontaktelemente 12 einer zweiten Bauart zur Realisierung eines über mehrere Anschlussmodule in Anreihrichtung X hinweg verlaufenden zweiten internen Busses auf.

Der zweite interne Bus dient vorzugsweise zur Übertragung von Daten und ggf. zur internen Energieversorgung der Anschlussmodule wohingegen der erste interne Bus vorzugsweise dazu genutzt wird, Energie zu übertragen, um beispielsweise an die Anschlussvorrichtungen 8 angeschlossene Feldgeräte mit Energie zu versorgen.

Die Kontaktelemente 11, 12 können beispielsweise Druckkontakte oder Gabel-/Messerkontakte sein. Sie können noch einen dritten Kontakt (nach oben) zur Kontaktierung der Leiterplatte 6 aufweisen.

Besonders vorteilhaft ist, dass die Basisklemmenträger 2 in einer Seitenansicht in Anreihrichtung - siehe beispielsweise Fig. 1a und Fig. 2a. eine Art U-Form aufweisen mit einem Grundschenkel 13, an welchem die Montagemittel - Rastmittel 3, 4 - zur Montage an der Tragschiene ausgebildet sind und der die Tragschiene vorzugsweise zu beiden Seiten senkrecht zur Anreihrichtung übergreift. Dabei sind an die voneinander abgewandten Enden des Grundschenkels 13 zur von der Tragschiene abgewandten Seite hin zwei senkrechte Seitenschenkel 14, 15 angeformt, so dass zwischen dem Grundschenkel und den Seitenschenkeln ein Aufnahmeraum 16 ausgebildet wird (siehe hierzu auch Fig. 4b).

Dieser Aufnahmeraum 16 kann rechtwinklig ausgebildet sein. Hier ist er trapezförmig, da die Seitenschenkel 14, 15 an ihren zueinander weisenden Seiten winklig zueinander ausgerichtet sind.

In den Aufnahmeraum 16 ist das Elektronikgehäuse 5 einsetzbar, welches eine an die Geometrie des Aufnahmeraums 16 angepasste Geometrie aufweist.

Vorzugsweise sind die Ränder 19 des Elektronikgehäuses 5 abschnittsweise derart ausgestaltet, dass sie zwischen Abschnitte einer Rückwand 17 und einer Frontwand 18 der Seitenschenkel 14, 15 des Basisklemmenträgers 2 geschoben werden können.

In das Elektronikgehäuse 5 ist vorzugsweise eine Leiterplatte 6 eingesetzt, welche beim Aufsetzen auf den Basisklemmenträger 2 dessen Kontakte kontaktiert, beispielsweise dadurch, dass ihre Randbereiche mit Kontaktbereichen in entsprechende Kontaktbereiche im Basisklemmenträger 2 eingreifen.

Es ist aber auch denkbar, dass eine oder mehrere flachliegende, teilweise kunststoffumspritzte Stromschiene anstelle der Leiterplatte eingesetzt werden. An die Stromschienen könnten dann bedrahtete elektrische oder elektronische Bauelemente - z.B. Relais - angelötet sein.

Es ist vorteilhaft, dass die Seitenschenkel 14, 15 des Basisklemmenträgers das Elektronikgehäuse 5 und die wenigstens eine Elektronikleiterplatte 6 zusätzlich schützend seitlich einfassen.

Die Anschlusseinheit 7 ist auf den Basisklemmenträger 2 aufsetzbar und zwar unabhängig von der Frage, ob auf den Basisklemmenträger 2 bereits das Elektronikgehäuse 5 aufgesetzt ist oder nicht.

So kann die Anschlusseinheit 7 sogar vorverdrahtet werden und wird in dem Fall, dass die Elektronikeinheit bzw. das Elektronikgehäuse 5 mit der Leiterplatte 6 montiert oder ausgetauscht werden muss, einfach nur geöffnet.

Dieses Öffnen - und ein entsprechendes Schließen - kann auf verschiedene Weise realisiert werden.

Nach einer Variante ist die Anschlusseinheit 7 beweglich, insbesondere schwenkbar, an dem Basisklemmenträger 2 gelagert.

So ist die Anschlusseinheit 7 zum Realisieren der Schwenkbarkeit der Anschlusseinheit 7 an dem Basisklemmenträger 2 nach Fig. 1 bis 6 mit einem der Seitenschenkel 14 über ein Schwenklager 21 verbunden.

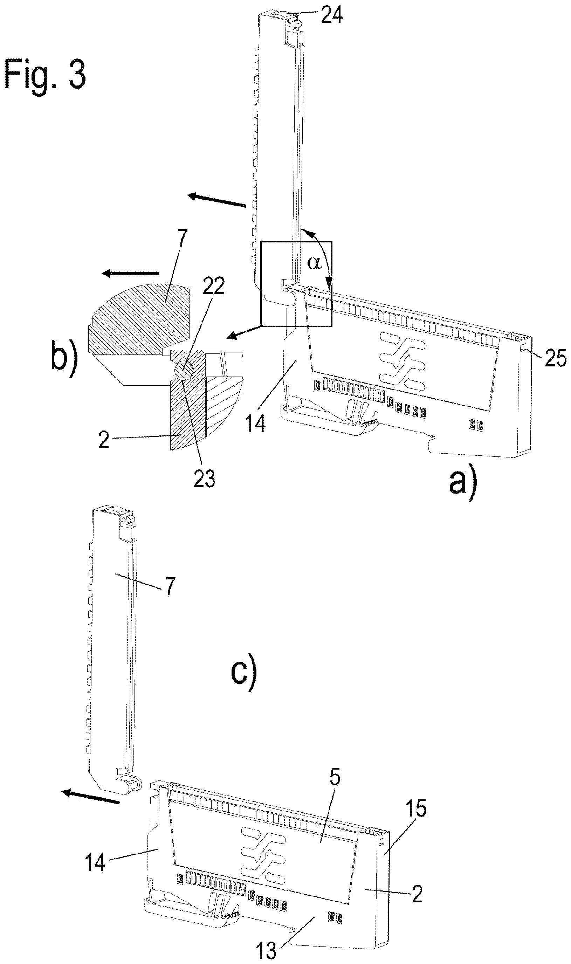

Hier weist das Schwenklager 21 eine Achse/Zapfen 22 an dem Gehäuse 10 der Anschlusseinheit 7 und einen Aufnahmeraum 23 als Lagerauge in dem einen Seitenschenkel 14 auf (siehe Fig. 2c). Dieser Aufnahmeraum 23 ist seitlich offen und derart bemessen, dass die Achse 22 in ihn einrastbar oder einschwenkbar und durch Überwinden der Rastung wieder aus ihm herausnehmbar ist (siehe insbesondere die Fig. 3a bis 3c und Fig. 6d).

Am anderen Seitenschenkel 15 kann ein lösbarer Verschluss ausgebildet sein. Dieser Verschluss wird hier durch eine beispielsweise durch Fingerdruck oder dgl. betätigbare Rasttaste 24 mit Rasthaken 25 und eine Rastausnehmung 26 im Seitenschenkel 15 gebildet (Fig. 2d).

Die Schwenkbarkeit ist jedenfalls derart bemessen, dass der Schwenkwinkel α dazu ausreicht, die Anschlussleiste abzunehmen, um die Elektronik einzustecken und/oder zu wechseln.

Vorzugsweise steht die Leiterplatte 6 zum Basisklemmenträger 2 und zur Anschlusseinheit 7 hin aus dem Elektronikgehäuse 5 vor.

Fig. 2e veranschaulicht das "Öffnen" des Anschlussmoduls 1 nach einem Drücken der Rasttaste 24 um einen zunächst noch geringen Öffnungswinkel α.

Fig. 3a zeigt ein Öffnen um 90° in einer vorzugsweise definierten, selbsthaltenden "Offenstellung". In dieser Stellung kann die Achse 22, welche abgeflacht ausgebildet ist, zur Seite aus dem als Lagerauge dienenden Aufnahmeraum 23 (nach oben in Richtung "-Z", Fig. 4a) herausgenommen werden, um sie zu wechseln oder auch, um sie erstmals zu montieren (Fig. 4, 5 und 6).

Fig. 4b zeigt das Elektronikgehäuse 5 oberhalb des Basisklemmenträgers 2.

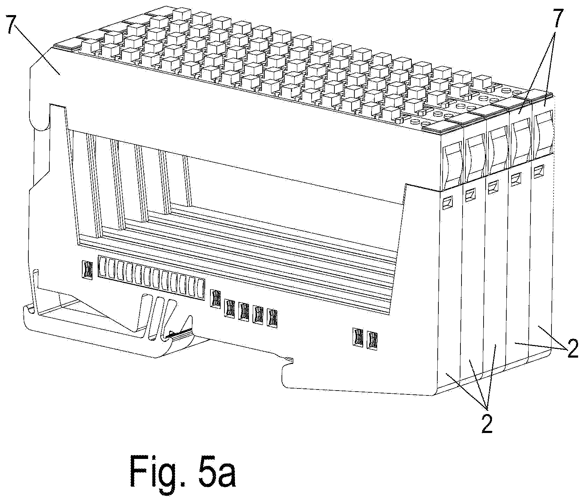

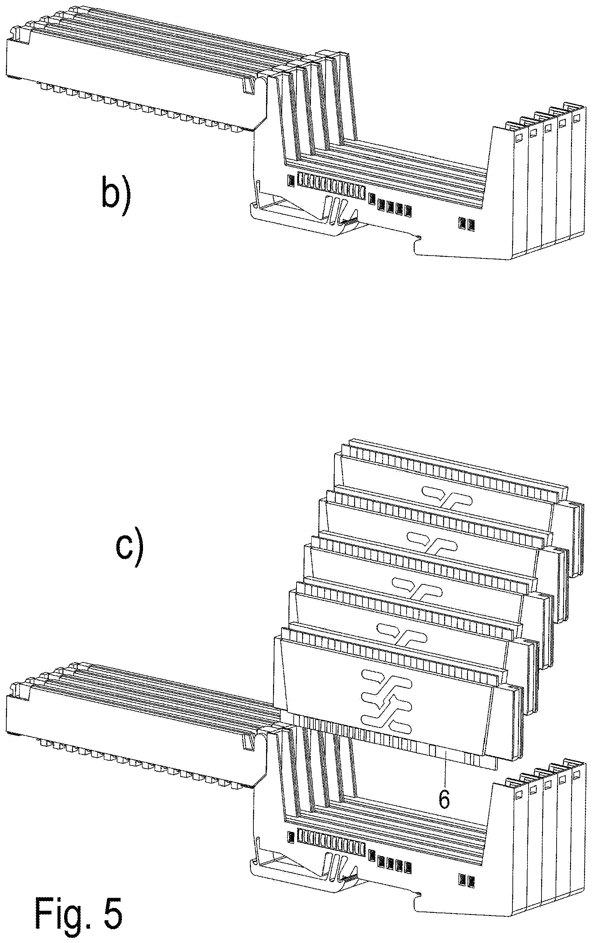

Fig. 5 zeigt, dass im Prinzip eine Reihung aus Basisklemmenträgern 2 mit den korrespondierenden Anschlusseinheiten 7 vormontiert gebildet werden kann, bevor die Elektronikgehäuse 5 in sie eingesetzt werden.

Als besonders vorteilhaft ist die dadurch entstehende Option zu erwähnen, dass die Verdrahtung der Anschlusseinheiten bzw. das Anschließen externer Leiter an die Anschlusseinheiten vor einem Einsetzen der Elektronikeinheiten erfolgen kann. Im Prinzip kann die gesamte Verdrahtung mit den Anschlusseinheiten 7 zur Seite "aufgeschwenkt" werden (Fig. 5a, b, c).

Bei der Erstmontage wird in der Regel zunächst auf einer Tragschiene ein Verbund aus den Basisklemmenträgern 2 gebildet (Fig. 6). Sodann werden die Elektronikgehäuse 5 eingesetzt (Fig. 6c), und dann die Anschlusseinheiten angesetzt (Fig. 6d) und geschlossen, um die Reihung aus Anschlussmodulen 1 mit Elektronikgehäusen 5 der Fig. 2a zu bilden.

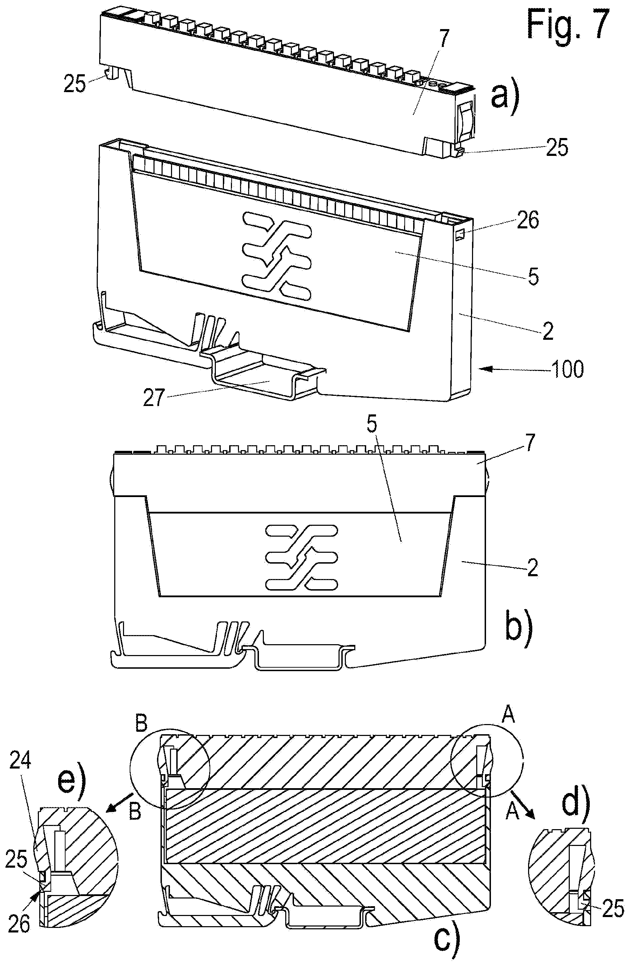

Nach der Alternative der Fig. 7 ist die Anschlusseinheit des Anschlussmoduls 100 zwar auch abnehmbar bzw. wechselbar. Hier ist jedoch die Option der Schwenkbarkeit der Anschlusseinheit 7 nicht gegeben. Stattdessen sind an beiden der Seitenschenkel lösbare Rastverbindungen vorgesehen. Hierzu ist an jedem der beiden Rastschenkel ein lösbarer Rasthaken 25 vorgesehen, der in eine Rastausnehmung 26 eingreift.

Fig. 7 zeigt auch die Anordnung des Basisklemmenträgers an der Tragschiene 27.

Es wäre alternativ auch denkbar, die Anschlusseinheit auf andere Weise lösbar an dem Basisklemmenträger 2 zu befestigen, so mittels Bajonettverschluss oder dgl. (hier nicht dargestellt).

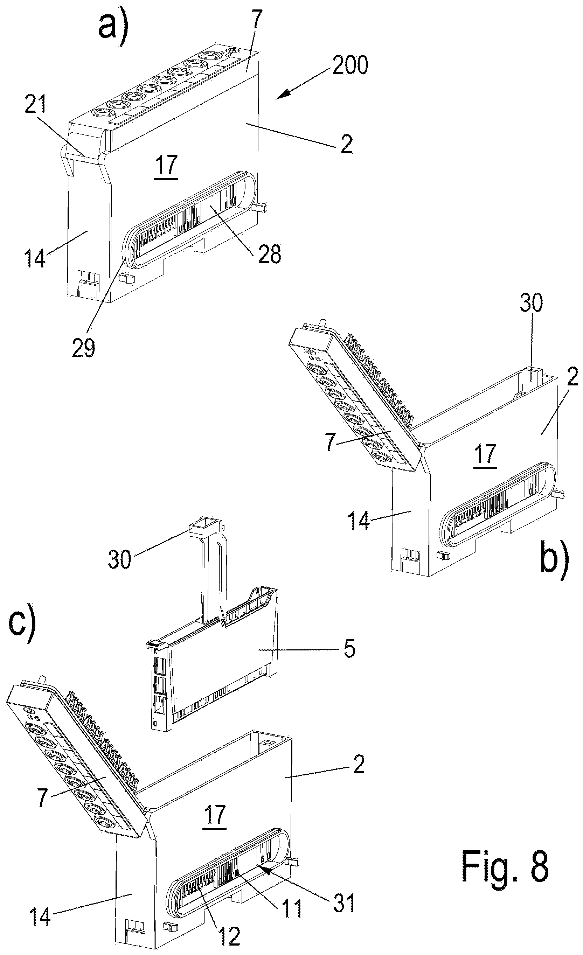

Fig. 8 zeigt in den Fig. 8(a) - (c) ein erfindungsgemäßes Anschlussmodul 200, bei dem die Seitenschenkel 14, 15 des Basisklemmenträgers 2 eine gemeinsame Rückwand 17 und Frontwand 18 bilden. In der Fig. 8(a) ist das Elektronikgehäuse 5 im und die Anschlusseinheit 7 in der Verschlussstellung am Basisklemmenträger 2 angeordnet. In der Fig. 8(b) befindet sich die Anschlusseinheit 200 in der Offenstellung. Und die Fig. 8(c) zeigt die Anschlusseinheit 200 bei entnommenem Elektronikgehäuse 5.

Bei der hier gezeigten Ausführungsform ist die Anschlusseinheit 7 um ein Schwenklager 21 schwenkbar an dem Basisklemmenträger 2 angeordnet. Am Elektronikgehäuse 5 ist eine Handhabung 30 in Form eines Griffes vorgesehen, um das Einfügen und Entnehmen des Elektronikgehäuses 5 in den und aus dem Basisklemmenträger 2 zu erleichtern.

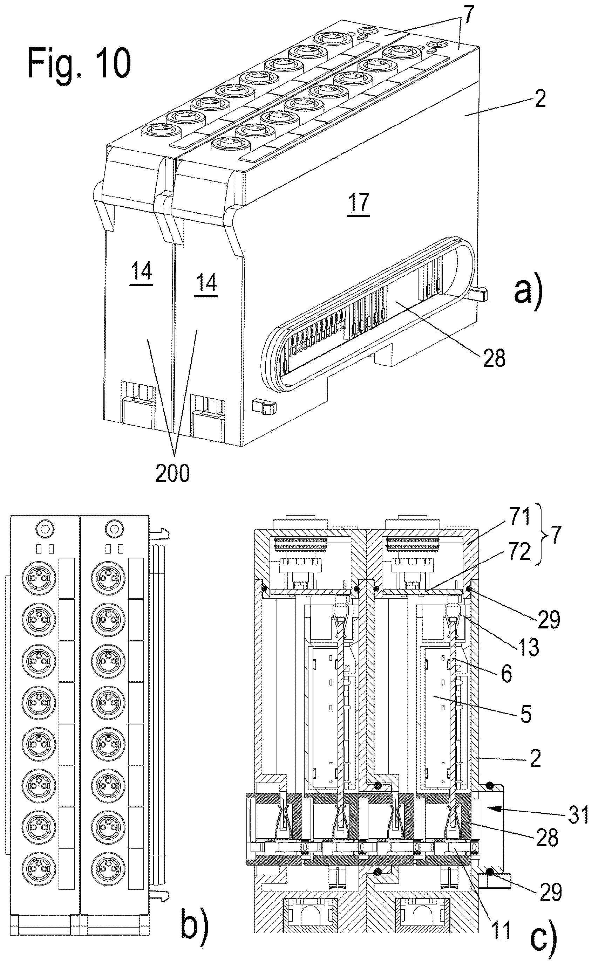

Im Basisklemmenträger 2 ist hier ein Kontaktmodul 28 angeordnet, mit dem Kontaktelemente 11, 12 vorgesehen sind, die ein elektrisches Kontaktieren des Anschlussmoduls 200 an ein benachbartes, aneinander gereihtes Anschlussmodul (s. Fig. 10) ermöglichen. Die Kontaktelemente 11, 12 sind durch eine Wandöffnung 31 zugänglich.

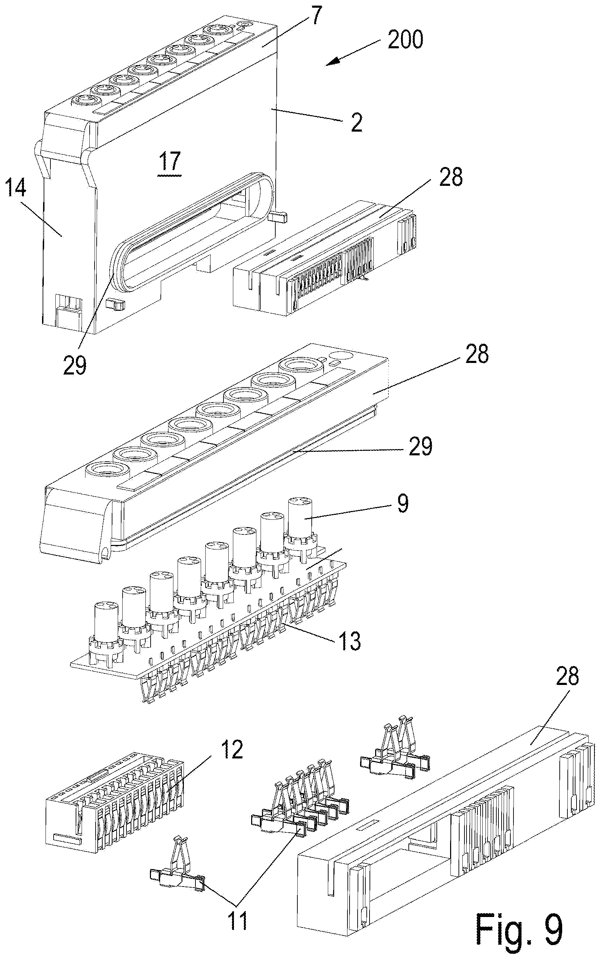

Fig. 9 zeigt die Bestandteile des Basisklemmenträgers 2 des Anschlussmoduls 200 der Fig. 8. Sichtbar ist zum Einen das Kontaktmodul mit den in das Kontaktmodul einfügbaren, hier einschiebbaren, Kontaktelementen 11, 12. Zum Anderen zeigt die Fig. 9, dass die Anschlusseinheit 7 hier aus einem Gehäuseteil 71 und einem Elektronikteil 72 gebildet ist. Am Elektronikteil 72 sind hier Betätigungselemente 9 und Kontaktelemente 13 zum elektrischen Kontaktieren des Elektronikgehäuses 5 vorgesehen.

Am Gehäuseteil 71 der Anschlusseinheit 7 und der Wandöffnung 31 des Basisklemmenträgers 2 ist jeweils eine Dichtung 29 vorgesehen, mit der ein dichtendes Verschließen des Anschlussmoduls 200 und/oder eines benachbarten Anschlussmoduls (s. Fig. 10) möglich ist, um eine höhere Schutzklasse im Vergleich zu den Ausführungsformen der Anschlussmodule 1, 100 der Fig. 1 - 7 zu ermöglichen.

Fig. 10 zeigt zwei aneinander gereihte Anschlussmodule 200 der Fig. 8, und zwar in der Fig. 10(a) in einer perspektivischen Ansicht, in der Fig. 10(b) in einer Draufsicht und in der Fig. 10(c) einen Schnitt durch die beiden benachbarten Anschlussmodule 200.

Die Fig. 10(c) zeigt das im Aufnahmeraum 16 des Basisklemmenträgers 2 angeordnete Elektronikgehäuse 5 mit der Leiterplatte 6, den Gehäuseteil 71 und den Elektronikteil 72 der Anschlusseinheit 7, wobei am Elektronikteil 72 die die Leiterplatte 6 elektrisch kontaktierenden Kontaktelementen 13 vorgesehen sind, das Kontaktmodul 28 mit seinen die Leiterplatte 6 elektrisch kontaktierenden Kontaktelementen 11 und die Wandöffnungen 31 in der Frontwand 18 sowie in der Rückwand 17, durch die die Kontaktelemente 11 des Kontaktmoduls 28 zum benachbarten Anschlussmodul 200 hin zugänglich sind.

Außerdem sind die Dichtungen 29 gezeigt, die eine hohe Schutzklasse der Anordnung ermöglichen. Dabei ermöglicht die an der Anschlusseinheit 7 angeordnete Dichtung 29 ein dichtendes Verschießen zwischen der Anschlusseinheit 7 und dem Basisklemmenträger 2 und die an der Wandöffnung 31 angeordnete Dichtung 29 ein dichtendes Verschließen zwischen einander benachbarten, aneinander gereihten Anschlussmodulen 200.

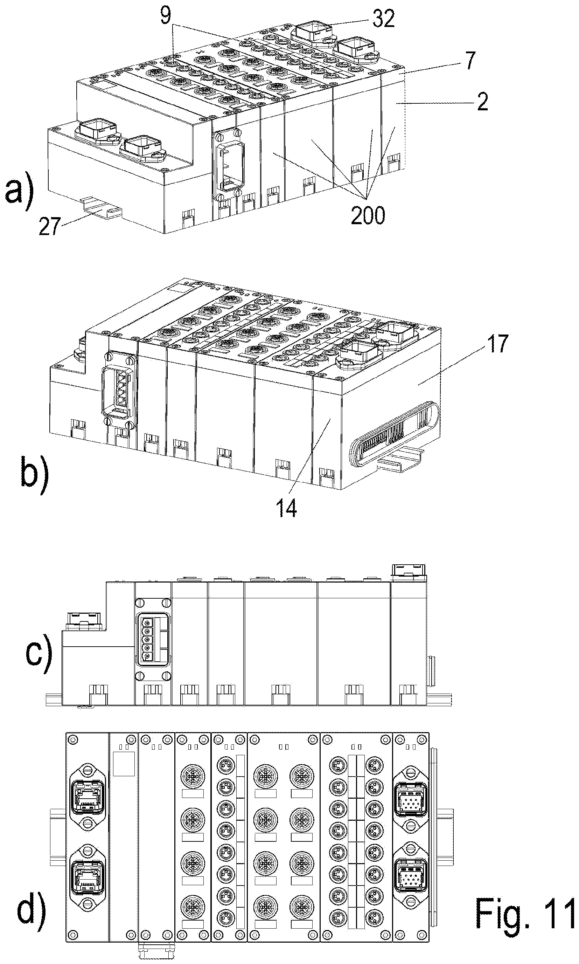

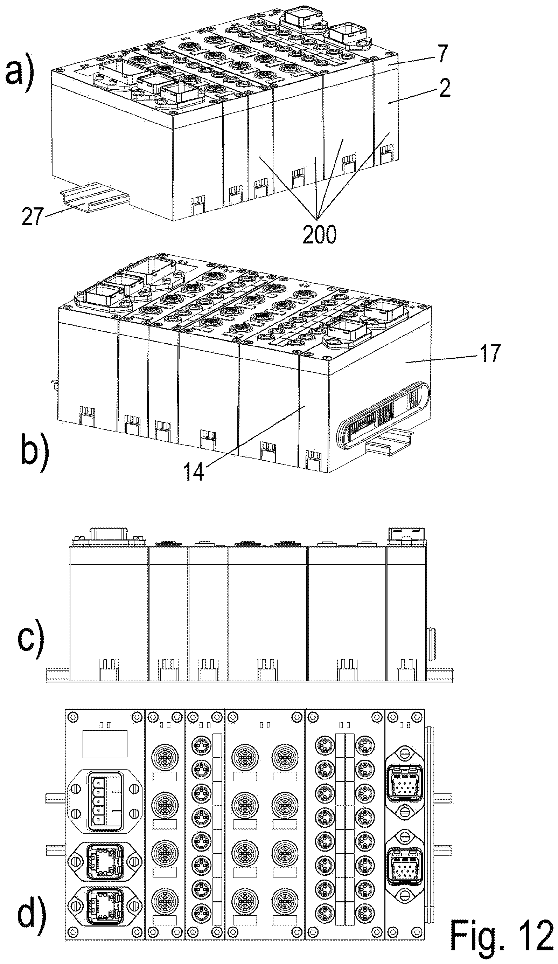

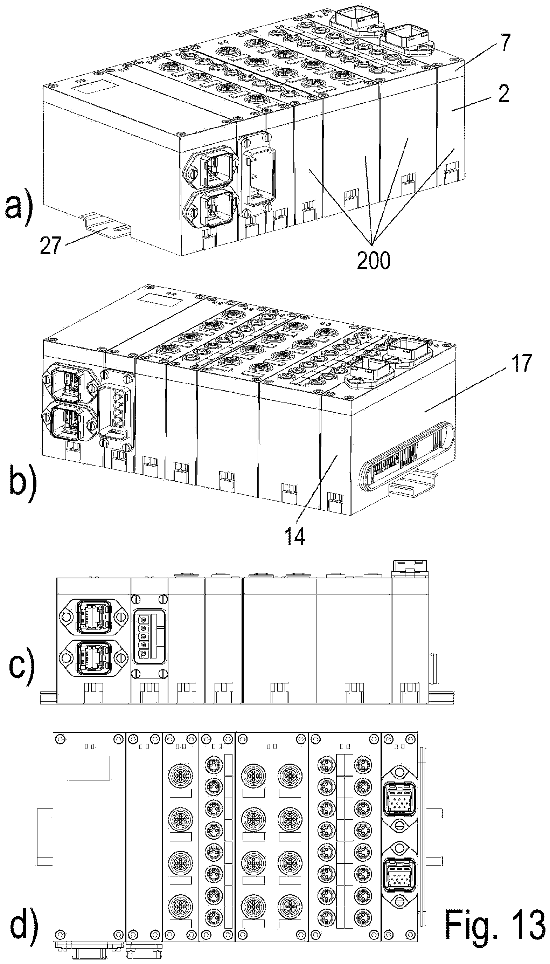

Fig. 11 - 13 zeigt verschiedenen Ausführungsformen von an einer Tragschiene 27 aneinandergereihten Anschlussmodulen 200 mit jeweils Basisklemmenträgern 2, deren Seitenschenkel 14, 15 jeweils eine gemeinsame Rückwand 17 und Frontwand 18 bilden. Die Anschlussmodule unterscheiden sich jeweils bezüglich ihrer Kontakt-, Betätigungs- und/oder Anschlusselemente 9, 11 - 13, 32.

### Bezugszeichen

- Anschlussmodule: 1
- Basisklemmenträger: 2
- Rastmittel: 3,4
- Elektronikgehäuse: 5
- Leiterplatte: 6
- Anschlusseinheit: 7
- Öffnung: 8
- Betätigungselement: 9
- Gehäuse: 10
- Kontaktelemente: 11, 12, 13
- Grundschenkel: 13
- Seitenschenkel: 14, 15
- Aufnahmeraum: 16
- Rückwand: 17
- Frontwand: 18
- Ränder: 19
- Schwenklager: 21
- Achse: 22
- Aufnahmeraum: 23
- Rasttaste: 24
- Rasthaken: 25
- Rastausnehmung: 26
- Tragschiene: 27
- Kontaktmodul: 28
- Dichtung: 29
- Handhabung: 30
- Wandöffnung: 31
- Anschlusselement: 32
- Anschlussmodul: 100
- Anschlussmodul: 200

## Patentansprüche

1. Busfähiges Anschlussmodul (1, 100) zur Steuerung und/oder Überwachung technischer Prozesse und/oder zur Industrie- und/oder Gebäudeautomatisierung mit einem scheibenartigen Aufbau mit folgenden Merkmalen:
a. einem Basisklemmenträger (2) zum Befestigen an einer Montagebasis, vorzugsweise mit Rastmitteln (3, 4) zum Aufrasten auf eine Tragschiene (27) versehen,
b. einem auf den Basisklemmenträger (2) aufsetzbaren Elektronikgehäuse (5) mit wenigstens einer Leiterplatte (6) oder einer Stromschienenanordnung, wobei die Leiterplatte (6) oder die Stromschienenanordnung in das Elektronikgehäuse (5) eingesetzt ist,
c. einer direkt am Basisklemmenträger (2) befestigbaren Anschlusseinheit (7) mit einem Gehäuse (10) mit wenigstens einer Reihe von Anschlussvorrichtungen zum Anschluss externer Leiter,
d. Kontaktelemente (11, 12) zum elektrischen Kontaktieren von an das Anschlussmodul angereihten benachbarten Anschlussmodulen, die im Basisklemmenträger (2) oder in einem in dem Basisklemmenträger (2) angeordneten Kontaktmodul (28) vorgesehen sind,
wobei
e. das Elektronikgehäuse (5) mit der darin eingesetzten Stromschiene oder Stromschienenanordnung nach Art eines umlaufenden Rahmens von dem Basisklemmenträger (2) und der Anschlusseinheit (7) eingefasst ist.

2. Anschlussmodul nach Anspruch 1, **dadurch gekennzeichnet, dass** die Anschlusseinheit (7) an dem Basisklemmenträger (2) beweglich angeordnet ist, um den Rahmen zu öffnen und zu schließen.

3. Anschlussmodul nach Anspruch 2, **dadurch gekennzeichnet, dass** die Anschlusseinheit (7) an dem Basisklemmenträger (2) in eine definierte Offenstellung und eine Verschlussstellung beweglich ist.

4. Anschlussmodul nach Anspruch 1, 2 oder 3, **dadurch gekennzeichnet, dass** der Basisklemmenträger einen U-förmigen Aufbau mit einem Grundschenkel (13) und Seitenschenkeln (14, 15) aufweist, so dass zwischen dem Grundschenkel und den Seitenschenkeln ein Aufnahmeraum (16) ausgebildet wird, in welchen das Elektronikgehäuse (5) einsetzbar ist.

5. Anschlussmodul nach einem der Ansprüche 2 bis 4, **dadurch gekennzeichnet, dass** die Anschlusseinheit (7) schwenkbar an dem Basisklemmenträger (2) angeordnet ist.

6. Anschlussmodul nach Anspruch 5, **dadurch gekennzeichnet, dass** die Anschlusseinheit (7) schwenkbar an einem der Seitenschenkel (14) des Basisklemmenträgers (2) angeordnet ist.

7. Anschlussmodul nach einem der vorstehenden Ansprüche, **dadurch gekennzeichnet, dass** die Anschlusseinheit (7) lösbar an dem Basisklemmenträger (2) angeordnet, insbesondere verrastet, ist.

8. Anschlussmodul nach einem der vorstehenden Ansprüche, **dadurch gekennzeichnet, dass** der Aufnahmeraum (16) rechtwinklig oder trapezförmig ausgebildet ist.

9. Anschlussmodul nach einem der vorstehenden Ansprüche, **dadurch gekennzeichnet, dass** das Elektronikgehäuse nicht am Basisklemmenträger (2) verrastet ist.

10. Anschlussmodul nach einem der vorstehenden Ansprüche, **dadurch gekennzeichnet, dass** Ränder (19) des Elektronikgehäuses abschnittsweise derart ausgestaltet sind, dass sie zwischen Abschnitte einer Rückwand (17) und einer Frontwand (18) der Seitenschenkel (14, 15) des Basisklemmenträgers (2) schiebbar sind.

11. Anschlussmodul nach einem der vorstehenden Ansprüche, **dadurch gekennzeichnet, dass** die Anschlusseinheit (7) auch auf den Basisklemmenträger (2) aufsetzbar ist, wenn das Elektronikgehäuse (5) noch nicht auf diesen aufgesetzt ist.

12. Anschlussmodul nach einem der vorstehenden Ansprüche, **dadurch gekennzeichnet, dass** die Anschlusseinheit (7) lediglich eine einzige Reihe der Anschlussvorrichtungen aufweist.

13. Anschlussmodul nach einem der vorstehenden Ansprüche, **dadurch gekennzeichnet, dass** die Seitenschenkel (14, 15) des Basisklemmenträgers (2) eine gemeinsame Rückwand (19) und Frontwand (18) bilden.

14. Anschlussmodul nach einem der vorstehenden Ansprüche, **dadurch gekennzeichnet, dass** es Dichtungen (29) zum dichtenden Verschließen des Anschlussmoduls und/oder mehrerer aneinandergereihter Anschlussmodule aufweist.

15. Reihung aus Anschlussmodulen nach einem oder mehreren der vorstehenden Ansprüche.

## Claims

1. Bus-capable connecting module (1, 100) for the control and/or monitoring of technical processes and/or for industrial and/or building automation with a disc-like structure with the following features:
a. a base terminal carrier (2) for attachment on the assembly base, preferably provided with catch means (3, 4) for locking upon a bus bar (27).
b. an electronic housing (5), which can be set upon the base terminal carrier (2), with at least one printed circuit board (6) or a bus bar arrangement, wherein the printed circuit board (6) or the bus bar arrangement is inserted into the electronic housing (5),
c. a connecting unit (7), which can be attached directly on the base terminal carrier (2) with a housing (10) with at least one row of connecting devices for the connection of external conductors,
d. contact elements (11, 12) for the electrical contacting of neighboring connecting modules lined up upon the connecting module that are provided in the base terminal carrier (2) or in a contact module (28) arranged in the base terminal carrier (2),
**characterized in that**
e. the electronic housing (5) with the bus bar or the bus bar arrangement inserted therein is framed in the manner of a circulating frame by the base terminal carrier (2) and connecting unit (7).

2. Connecting module according to Claim 1, **characterized in that** the connecting unit (7) is movably arranged on base terminal carrier (2) in order to open and close the frame.

3. Connecting module according to Claim 2, **characterized in that** the connecting unit (7) is movable on the base terminal carrier (2) into a defined open position and a locking position.

4. Connecting module according to Claims 1, 2, or 3, **characterized in that** the base terminal carrier has a U-shaped structure with a base leg (13) and side legs (14, 15) so that there is formed between the base leg and the side legs a receiving space (16) into which one can insert electronic housing (5).

5. Connecting module according to one of Claims 2 to 4, **characterized in that** the connecting unit (7) is arranged swingably on base terminal carrier (2).

6. Connecting module according to Claim 6, **characterized in that** the connecting unit (7) is arranged swingably on one of the side legs (14) of the base terminal carrier (2).

7. Connecting module according to one of the above claims, **characterized in that** connecting unit (7) is arranged, preferably locked, separably upon base terminal carrier (2)

8. Connecting module according to one of the above claims, **characterized in that** the receiving space (16) is rectangular or trapezoidal.

9. Connecting module according to one of the above claims, **characterized in that** the electronic housing is not locked upon the base terminal carrier (2).

10. Connecting module according to one of the above claims, **characterized in that** edges (19) of the electronic housing are so shaped segmentally that they can be pushed between segments of a back wall (17) and a front wall (18) of side legs (14, 15) of base terminal carrier (2).

11. Connecting module according to one of the above claims, **characterized in that** the connecting unit (7) should also be set upon base terminal carrier (2) if electronic housing (5) has not yet been set upon the latter.

12. Connecting module according to one of the above claims, **characterized in that** connecting unit (7) merely has a single row of connection devices.

13. Connecting module according to one of the above claims, **characterized in that** the side legs (14, 15) of the base terminal carrier (2) form a common back wall (19) and front wall (18).

14. Connecting module according to one of the above claims, **characterized in that** it has seals (29) for the sealing locking of the connecting module and/or several mutually aligned connecting modules.

15. Lineup of connecting modules according to one or several of the above claims.

## Revendications

1. Module de connexion (1, 100) compatible avec un bus pour la commande et/ou la surveillance de processus techniques et/ou pour l'automatisation d'installations industrielles ou domotiques, construit en forme de disque et présentant les caractéristiques suivantes :
a. un bornier de base (2) destiné à être fixé sur un socle de montage, de préférence avec des moyens d'enclenchement (3, 4) à enclencher sur un rail de support (27),
b. un boîtier électronique (5) pouvant être posé sur le bornier de base (2) avec au moins une carte de circuits (6) ou un jeu de barres, la carte de circuits (6) ou le jeu de barres étant inséré dans le boîtier électronique (5),
c. une unité de connexion (7) pouvant être fixée directement au bornier de base (2) avec un boîtier (10) comportant au moins une rangée de dispositifs de connexion pour la connexion de conducteurs extérieurs,
d. des éléments de contact (11, 12) pour la mise en contact électrique de modules de contacts voisins alignés sur le module de contact, qui sont prévus dans le bornier de base (2) ou dans un module de contact (28) disposé dans le bornier de base (2),
dans lequel
e. le boîtier électronique (5) avec la barre collectrice ou le jeu de barres qu'il contient est entouré à la manière d'un cadre périphérique par le bornier de base (2) et l'unité de connexion (7).

2. Module de connexion selon la revendication 1, **caractérisé en ce que** l'unité de connexion (7) est disposée de façon mobile sur le bornier de base (2) afin d'ouvrir et de fermer le cadre.

3. Module de connexion selon la revendication 2, **caractérisé en ce que** l'unité de connexion (7) est mobile sur le bornier de base (2) dans une position d'ouverture définie et une position de fermeture.

4. Module de connexion selon la revendication 1, 2 ou 3, **caractérisé en ce que** le bornier de base présente une structure en forme de U avec un bras de fond (13) et des bras latéraux (14, 15), de façon à former entre le bras de fond et les bras latéraux un espace de logement (16) dans lequel le boîtier électronique (5) peut être inséré.

5. Module de connexion selon l'une des revendications 2 à 4, **caractérisé en ce que** l'unité de connexion (7) est disposée de façon pivotante sur le bornier de base (2).

6. Module de connexion selon la revendication 5, **caractérisé en ce que** l'unité de connexion (7) est disposée de façon pivotante sur l'un des bras latéraux (14) du bornier de base (2).

7. Module de connexion selon l'une des revendications précédentes, **caractérisé en ce que** l'unité de connexion (7) est disposée de façon amovible sur le bornier de base (2), en particulier enclenchée.

8. Module de connexion selon l'une des revendications précédentes, **caractérisé en ce que** l'espace de logement (16) a une forme rectangulaire ou trapézoïdale.

9. Module de connexion selon l'une des revendications précédentes, **caractérisé en ce que** le boîtier électronique n'est pas enclenché sur le bornier de base (2).

10. Module de connexion selon l'une des revendications précédentes, **caractérisé en ce que** des bords (19) du boîtier électronique sont conformés en partie de façon à pouvoir être insérés entre des parties d'une paroi arrière (17) et une paroi avant (18) des bras latéraux (14, 15) du bornier de base (2).

11. Module de connexion selon l'une des revendications précédentes, **caractérisé en ce que** l'unité de connexion (7) peut être posée sur le bornier de base (2) quand le boîtier électronique (5) n'est pas encore posé sur celui-ci.

12. Module de connexion selon l'une des revendications précédentes, **caractérisé en ce que** l'unité de connexion (7) comprend une seule rangée de dispositifs de connexion.

13. Module de connexion selon l'une des revendications précédentes, **caractérisé en ce que** les bras latéraux (14, 15) du bornier de base (2) forment une paroi arrière (19) et une paroi avant (18) communes.

14. Module de connexion selon l'une des revendications précédentes, **caractérisé en ce qu'**il comporte des joints d'étanchéité (29) pour la fermeture hermétique du module de connexion et/ou de plusieurs modules de connexion alignés.

15. Alignement de modules de connexion selon une ou plusieurs des revendications précédentes.
